(19) Europäisches Patentamt / European Patent Office / Office européen des brevets

(11) **EP 2 243 219 B1**

(12) **EUROPÄISCHE PATENTSCHRIFT**

(45) Veröffentlichungstag und Bekanntmachung des Hinweises auf die Patenterteilung:
**08.05.2013 Patentblatt 2013/19**

(51) Int Cl.:
**H03H 17/04** *(2006.01)*   **H03H 17/02** *(2006.01)*

(21) Anmeldenummer: **09703061.3**

(86) Internationale Anmeldenummer:
**PCT/EP2009/050168**

(22) Anmeldetag: **08.01.2009**

(87) Internationale Veröffentlichungsnummer:
**WO 2009/090135 (23.07.2009 Gazette 2009/30)**

(54) **DIGITALES OPTIMAL-FILTER FÜR PERIODISCHE WECHSELSIGNALE**

DIGITAL OPTIMAL FILTER FOR PERIODICALLY ALTERNATING SIGNALS

FILTRE OPTIMAL NUMÉRIQUE POUR SIGNAUX D'ALTERNANCE PÉRIODIQUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **14.01.2008 EP 08100417**
**13.08.2008 EP 08162320**

(43) Veröffentlichungstag der Anmeldung:
**27.10.2010 Patentblatt 2010/43**

(73) Patentinhaber: **ELMOS Semiconductor AG**
**44227 Dortmund (DE)**

(72) Erfinder:
• **SPIEGEL, Egbert**
**45891 Gelsenkirchen (DE)**
• **KRIBUS, Andreas**
**44799 Bochum (DE)**

(74) Vertreter: **von Kreisler Selting Werner**
**Deichmannhaus am Dom**
**Bahnhofsvorplatz 1**
**50667 Köln (DE)**

(56) Entgegenhaltungen:
**EP-A2- 0 285 325**

• **STERNAD M ET AL: "THE STRUCTURE AND DESIGN OF REALIZABLE DECISION FEEDBACK EQUALIZERS FOR IIR CHANNELS WITH COLORED NOISE" IEEE TRANSACTIONS ON INFORMATION THEORY, IEEE, US, Bd. 36, Nr. 4, 1. Juli 1990 (1990-07-01), Seiten 848-858, XP000133778 ISSN: 0018-9448**

• **LIANG-MING B ET AL: "MATCHED RECURSIVE DIGITAL FILTERS" FREQUENZ, Bd. 44, Nr. 7/08, 1. Juli 1990 (1990-07-01), Seiten 197-199, XP000151430 SCHIELE UND SCHON, BERLIN, DE ISSN: 0016-1136**

• **DATABASE INSPEC [Online] THE INSTITUTION OF ELECTRICAL ENGINEERS, STEVENAGE, GB; Januar 1986 (1986-01), KRISTOFFERSEN K: "Optimal receiver filtering in pulsed Doppler ultrasound blood velocity measurements" XP002530128 Database accession no. 2683399 & IEEE Transactions on Ultrasonics, Ferroelectrics and Frequency Control USA, Bd. UFFC-33, Nr. 1, Januar 1986 (1986-01), Seiten 51-58, ISSN: 0885-3010**

• **STEVEN W. SMITH: "The Scientist and Engineer's Guide to Digital Signal Processing" [Online] 2007, , XP002530126 Gefunden im Internet: URL: http://www.dspguide.com/CH17.PDF> [gefunden am 2009-05-28] Chapter 17: "Custom Filters", pages 297 - 310 Seite 307, Absatz 2 - Seite 310, Absatz 2; Abbildungen**

• **STEVEN W. SMITH: "The Scientist and Engineer's Guide to Digital Signal Processing" [Online] 2007, , XP002530127 Gefunden im Internet: URL: http://www.dspguide.com/ch17/3.htm> [gefunden am 2009-05-28] Chapter 17/3 Pages 1-5 das ganze Dokument**

EP 2 243 219 B1

## Beschreibung

Die Erfindung betrifft ein digitales Optimal-Filter zum Herausfiltern eines periodischen Wechselsignals (z B Burst-Signal) und insbesondere eines sinusförmigen Signals mit einer vorgebbaren Periodenanzahl (sogenannte Burst-Signale) aus einem (verrauschten) Signal.

Damit erzeugen also Optimal-Filter auf einen Impuls an ihrem Eingang ein Signal an ihrem Ausgang, dessen Verlauf gleich dem zeitlich inversen Verlauf eines vorgegebenen gewünschten Signals ist. Somit lassen sich mit Optimal-Filtern aus einem Ausgangssignal gewünschte Signalverläufe extrahieren (herausfiltern), etwa sogenannte sinusförmige "Burst"-Signale, die beispielsweise für die Abstandsmessung im Automotive-Bereich (z.B. Park Distance Control, PDC) verwendet werden. Dabei geht es darum, aus dem verrauschten Reflexionssignal des "Burst"-Sendesignals die "Burst"-Impulse zu extrahieren, um dann über Laufzeitmessung o.dgl den Abstand eines Fahrzeuges zu einem Hindernis zu ermitteln

Es ist bekannt, bei Transversal-(FIR-)Filtern den Verlauf des gewünschten herauszufilternden Signals durch dieses beschreibende Abtastwerte als Koeffizienten abzulegen. Je nach Komplexität des Signalverlaufs und seiner Länge werden zur Beschreibung des Signals eine Vielzahl von Koeffizienten benötigt. Daher und auch wegen der Realisierung von Multiplikationsfunktionen im FIR-Filter ist der Hardware-Aufwand zu ihrer schaltungstechnischen Realisierung relativ hoch.

EP-A-0 285 325 offenbart ein digitales Optimal-Filter zum Herausfiltern eines periodischen Wechselsignals mit einem vorgegebenen Periodenzahl aus dem Eingangssignal des Optimal-Filters. Das bekannte Optimal-Filter ist versehen mit einem Transversal-Filter, das ein erstes Schieberegister mit einem Eingang und einer Anzahl von Zellen aufweist, die jeweils einen Ausgang aufweisen, wobei den Ausgängen Koeffizienten zugeordnet sind, welche entsprechend den Abtastwerten bzw. gleich den Abtastwerten gewählt sind, und einem ersten Summierer zum Summieren der mit den jeweils zugeordneten Koeffizienten gewichteten Ausgängen der Zellen des ersten Schieberegisters, wobei der Ausgang des ersten Summierers den Ausgang des Transversal-Filters bildet.

Aufgabe der Erfindung ist es, zur Extraktion eines periodischen Wechselsignals mit einer vorgegebenen, begrenzten Anzahl von Perioden aus einem gegebenen Signal ein einfach aufgebautes digitales Optimal-Filter anzugeben.

Zur Lösung dieser Aufgabe wird mit der Erfindung ein digitales Optimal-Filter zum Herausfiltern eines periodischen Wechselsignals, insbesondere sinus-förmigen Signals, mit einer vorgegebenen Periodenanzahl aus einem gegebenen Signal vorgeschlagen, wobei das digitale Optimal-Filter versehen ist mit der Merkmalen des Anspruchs 1.

Die Erfindung betrifft die Hardware-Implementierung eines Optimal-Filters für insbesondere sinusförmige Burst-Signale. Eine derartige Signalform wird beispielsweise bei der Ultraschall-basierten Abstandsmessung (unter anderem Einparkhilfe im Auto) verwendet Die erfindungsgemäße Implementierung umfasst die folgenden Schritte:

- Zerlegung der Übertragungsfunktion des Optimal-Filters in einen rekursiven und einen transversalen Anteil.
- Realisierung des rekursiven Anteils mit Pol-Nullstelle-Paar bei $z=e^{j2\pi f}$ (f = Sinusfreewenz), so dass sich bezogen auf das Ein-/Ausgangsverhalten weiterhin ein Filter mit endlicher Pulsantwort (FIR) ergibt.
- Flächensparende Realisierung des rekursiven Anteils mit RAM. Uber die Speichertiefe lässt sich die Bandbreite des Filters einstellen
- Multiplikationsfreie Realisierung des FIR-Anteils mit Hilfe von Koeffizienten in CSD-Kodierung (CSD = Canonical Signed Digit).

## Einführung

Die Erfindung wird nachfolgend unter Bezugnahme auf die Zeichnung näher erläutert. Im einzelnen zeigen dabei:

Abb. 1          ein idealisiertes Burst-Signal,

Abb 2          ein verrauschtes Burst-Signal,

Abb. 3          das Signal am Ausgang des Optimal-Filters,

Abb 4          ein Transversal-Filter (FIR-Filter),

Abb. 5          die Impulsfolge zur Ansteuerung eines Transversalfilters mit halber Periode,

Abb. 6          die Schaltung zur Generierung der Pulsfolge 1 0 0 0 - 1 0 0 0 1 0,

Abb. 7                    die vorgeschaltete Schaltung zur Löschung der Pulsfolge,

Abb. 8                    die vollständige Filterstruktur für den Fall von 8 Abtastwerten/Periode,

Abb. 9                    die Filterstruktur im Z-Bereich und

Abb. 10 bis Abb. 19    Darstellungen der internen Filterzustände bei Anlegen eines Impulses am Eingang.

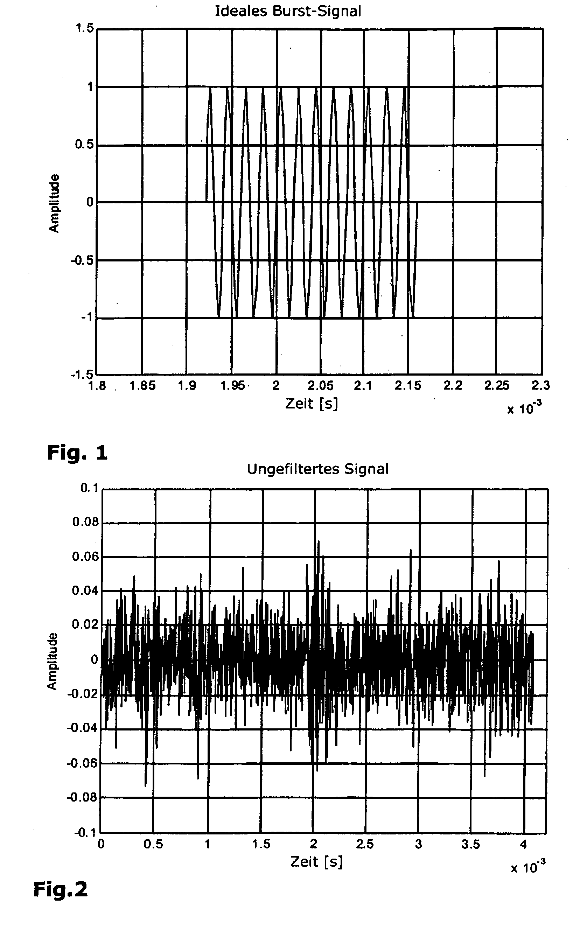

Bei der Ultraschall-basierten Abstandsmessung werden sinusförmige Burst-Signale verwendet, die idealerweise so, wie in Abb. 1 wiedergegeben, aussehen.

Nachdem das Signal den Empfangsverstärker durchlaufen hat, ist diesem ein Rauschsignal überlagert. Bei weit entfernten Objekten ist dieses Signal im Rauschen verschwunden (siehe Abb. 2).

Durch eine geeignete Filterung kann dieses Signal aus dem Rauschen extrahiert werden. Ist das Signal bekannt, kann durch eine geeignete Dimensionierung der Rauschabstand am Ausgang des Filters maximiert werden. Ein solches Filter wird als Optimal-Filter bezeichnet. Aus der Theorie ist bekannt, dass die Impulsantwort eines Optimal-Filters die zeitliche Umkehrung des zu detektierenden Signals ist. Da im vorliegenden Fall das Signal symmetrisch ist, ist die Impulsantwort gleich dem Signal. Liegt das Signal digital in zeitdiskreter Form vor, lässt sich ein solches Filter sehr leicht als FIR-Filter konstruieren (FIR=Finite Impulse Response)

$$H(z) = b_0 + b_1 z^{-1} + b_2 z^{-2} + \cdots + b_N z^{-N}$$

Im vorliegenden Fall des Sinus-Bursts können die Koeffizienten (z.B. in MATLAB programmiert) wie folgt berechnet werden (N=Anzahl der Abtastwerte pro Periode, P=Anzahl der Perioden)

for i = 0 : N* P - 1

$$b_i = \sin\left(2\pi \frac{i}{N}\right)$$

end

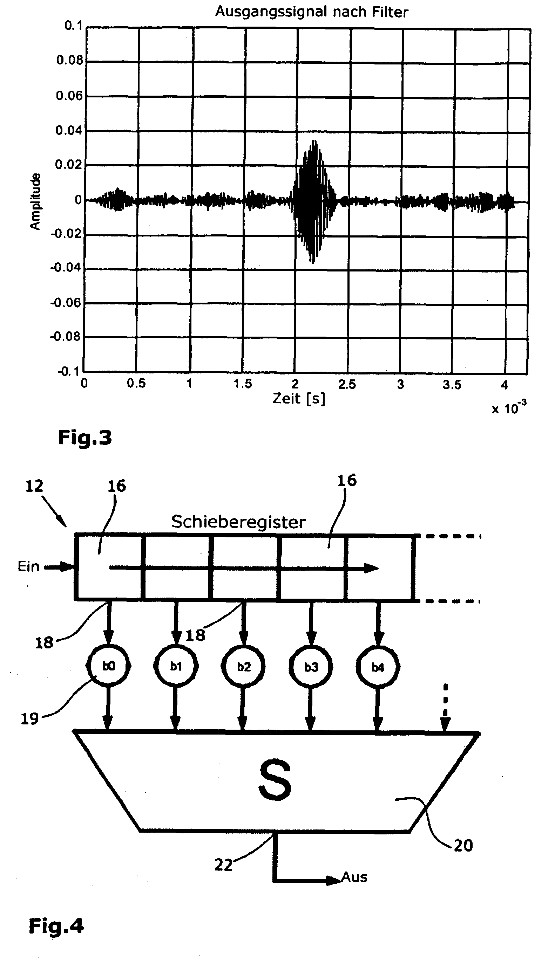

Abb. 3 zeigt die Antwort des so konstruierten Optimal-Filters auf das rauschbehaftete Empfangssignal (siehe im Vergleich dazu auch Abb. 2).

Obwohl die mathematische Darstellung als FIR-Filter sehr einfach ist, stößt die Realisierung auf einen Signalprozessor oder in Hardware auf Grund der hohen Anzahl an Multiplikationen und Additionen sehr schnell an Grenzen. Die folgenden Abschnitte beschreiben eine flächengünstige Implementierung durch Umwandlung in eine äquivalente Darstellung.

**Design Ziel**

Ziel ist die Konstruktion eines Filters, dessen Impulsantwort dem zeitlich inversen Sendesignal entspricht. Zur Vereinfachung wird das ideale Sendesignal, ein Sinus-Burst mit P Perioden angenommen. Die Abtastung erfolgt z.B. mit 8 Samples pro Periode (M = 8) mit der Abtastfrequenz (Samplefrequenz) $f_s$.

Um das optimale Filter zu realisieren müsste man N = M * P Werte, mit den entsprechenden Koeffizienten (bj-siehe Abb.4) gewichtet, aufaddieren. Bei einem Sinus-Burst mit einer Länge von 12 Perioden wären das 95 Additionen und 96 Multiplikationen mit den sich periodisch wiederholenden Koeffizienten

$$\left[\sin\left(\frac{\pi}{4}\right), \sin\left(\frac{\pi}{2}\right), \sin\left(\frac{3\pi}{4}\right), \sin(\pi), \sin\left(\frac{5\pi}{4}\right), \sin\left(\frac{3\pi}{2}\right), \sin\left(\frac{7\pi}{4}\right), \sin(2\pi)\right]$$

$$= \left[\frac{1}{\sqrt{2}}, 1, \frac{1}{\sqrt{2}}, 0, -\frac{1}{\sqrt{2}}, -1, -\frac{1}{\sqrt{2}}, 0\right]$$

Unter Berücksichtigung der Null- und der Eins-Koeffizienten sowie des mehrfach auftretenden Koeffizienten sind es noch 72 Additionen und 12 Multiplikationen notwending.

Um diese hohe Anzahl der Operationen zu reduzieren, wird eine rekursive Filter-Struktur hergeleitet, die äquivalent zu diesem Filter ist.

Anzumerken sei an dieser Stelle, dass dieses Filter einer laufenden Diskreten Fourier Transformation (DFT) über die letzten N Samples an der normierten entspricht. Kreisfrequenz entspricht.

Realisierung eines geeigneten Optimal-Filter mit sinusförmiger Impulsantwort

Wie eingangs erwähnt, lässt sich ein Filter mit einer sinusförmigen Impulsantwort mit Hilfe einer transversalen Filterstruktur leicht realisieren (siehe Abb. 4).

Das digitale Eingangswort wird links in das (nach Anspruch 1 erste) Schieberegister 12 eingespeist und mit jedem Systemtakt eine Position nach rechts verschoben. Die Ausgänge 18 der Zellen 16 (Register) des Schieberegisters 12 werden mit den Koeffizienten ($b_i$) 19 gewichtet und aufsummiert. Zur Bestimmung der Impulsantwort wird nur ein einzelnes von null verschiedenes Digitalwort auf den Eingang gegeben Die übrigen Digitalworte sind null. Mit jedem Systemtakt wird dieses einzelne Wort nacheinander jeweils mit einem anderen Koeffizienten gewichtet über den Summierer 20 auf den Ausgang gegeben Entsprechen die Koeffizienten 19 den Werten eines Sinussignals zu den jeweiligen Zeitpunkten, ist die Impulsantwort sinusförmig. Grundsätzlich lassen sich mit dieser Struktur beliebige Impulsantworten erzeugen Allerdings ist der Rechen- bzw. Hardware-Aufwand beträchtlich, so dass eine direkte Umsetzung nicht wirtschaftlich ist.

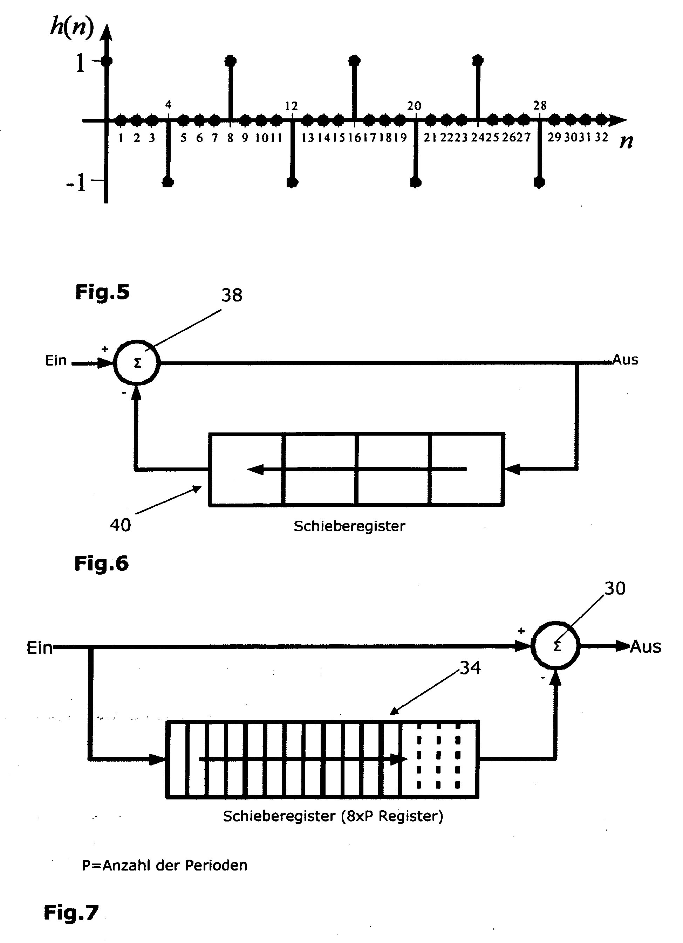

Bei einem Filter mit sinusförmiger Impulsantwort wiederholen sich die Koeffizienten periodisch. Innerhalb einer Periode wiederholen sich die Koeffizienten ebenfalls, allerdings mit umgekehrtem Vorzeichen. Konstruiert man nun ein transversales Filter mit den Koeffizienten für lediglich eine halbe Sinuskurve (halbe Periode) und speist dieses mit einer entsprechenden Folge von "1", "0" und "-1" Werten, erhält man ebenfalls ein sinusförmiges Ausgangssignal Für den Fall von 8 Abtastwerte/Periode ergibt sich die Impulsfolge gemäß Abb. 5.

Eine "1" gefolgt von drei "0" generiert eine positive Sinushalbwelle, eine "-1" gefolgt von drei "0" eine negative. Eine Schaltung, die eine derartige Pulsfolge generiert, kann mit Hilfe eines rückgekoppelten (nach Anspruch 1 dritten) Schieberegisters 40 und eines (nach Anspruch 1 dritten) Summierers 38 gemäß Abb. 6 gebildet werden.

Wird eine einzelne "1" am Eingang (In) angelegt, so erscheint diese direkt am Ausgang (Out). Nach einer Verzögerung von 4 Systemtakten wird sie mit umgekehrtem Vorzeichen auf den Summierer 38 gegeben und erscheint als "-1" am Ausgang. Nach weiteren 4 Takten ergibt sich wieder eine "1". Da sich dieser Vorgang beliebig lange fortsetzt, muss er entsprechend der Anzahl der Perioden nach einer bestimmten Zeit wieder gelöscht werden. Dazu dient die Schaltung nach Abb. 7, bei der ein weiteres (nach Anspruch 1 zweites) Schieberegister 34 und ein (nach Anspruch 1 zweiter) Summierer 30 verwendet wird.

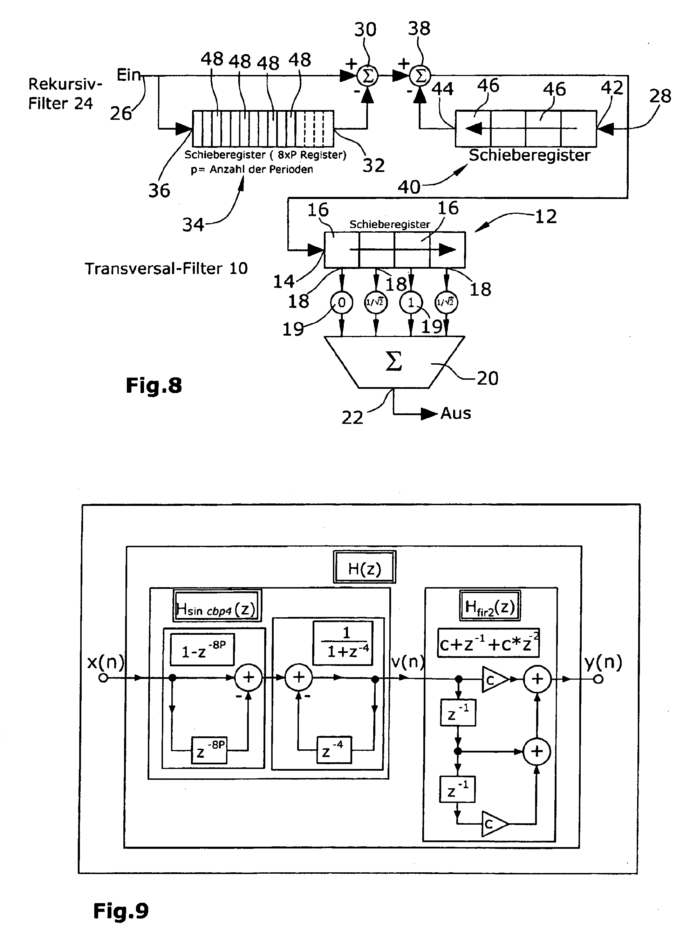

Wird also eine einzelne "1" an den Eingang (In) gelegt, erscheint diese direkt am Ausgang (Out). Nach 8*P Systemtakten (entsprechend P Perioden und 8 Abtastwerten/Periode) erscheint diese "1" auch am Ausgang 32 des Schieberegisters 34 und damit als "-1" am Ausgang (Out) der Schaltung nach Abb. 7 Sie trifft dann mit einer "1" am Ausgang des Schieberegisters der nachfolgenden Schaltung zusammen, so dass sich in der Summe null ergibt. Die gesamte Filterschaltung hat somit die Struktur gemäß Abb. 8

Die Filterstruktur kann mit Hilfe der Z-Transformation in die entsprechenden Ubertragungsfunktionen überführt werden (siehe Abb. 9).

Als Übertragungsfunktion ergibt sich:

$$H(z) = H_{sin\,cbp4}(Z) * H_{fir2}(Z) = \frac{1-z^{-8P}}{1+z^{-4}}\left(\frac{1}{\sqrt{2}} + z^{-1} + \frac{1}{\sqrt{2}} \cdot z^{-2}\right)$$

Die Verwendung von 8 Abtastwerten ist nur exemplarisch zu sehen. Grundsätzlich sind alle geradzahligen Werte geeignet.

Die Übertragungsfunktion kann auch mit Äquivalenzumformungen mathematisch hergeleitet werden.

**Beispiel**

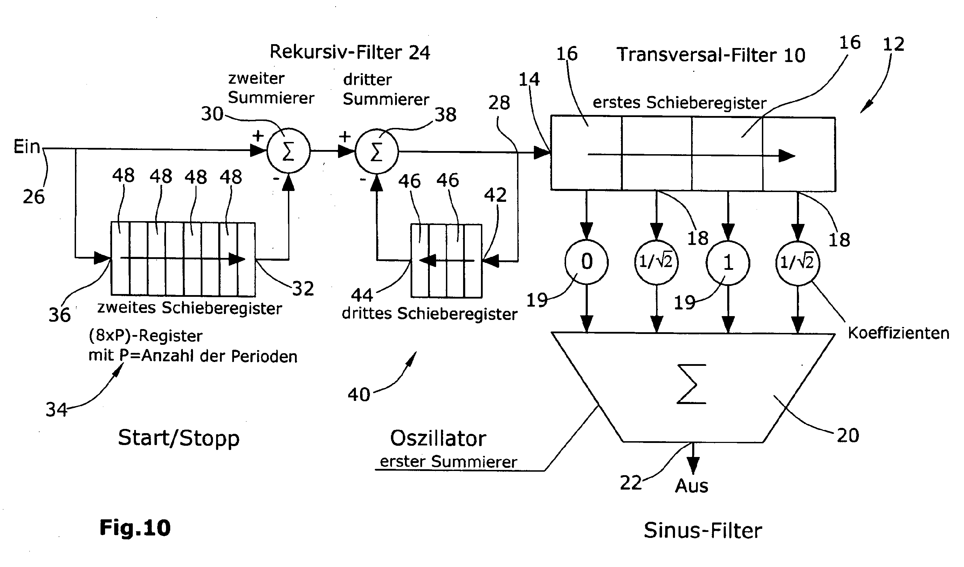

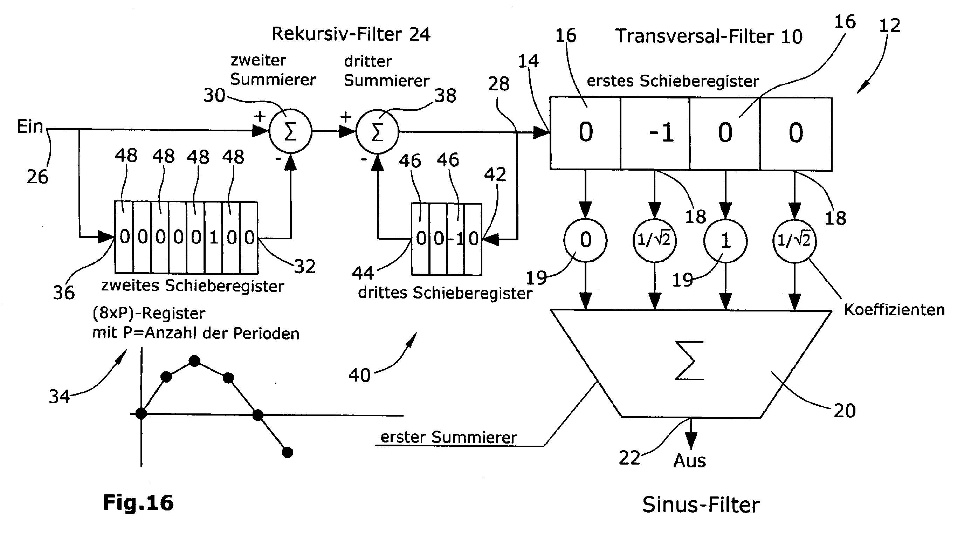

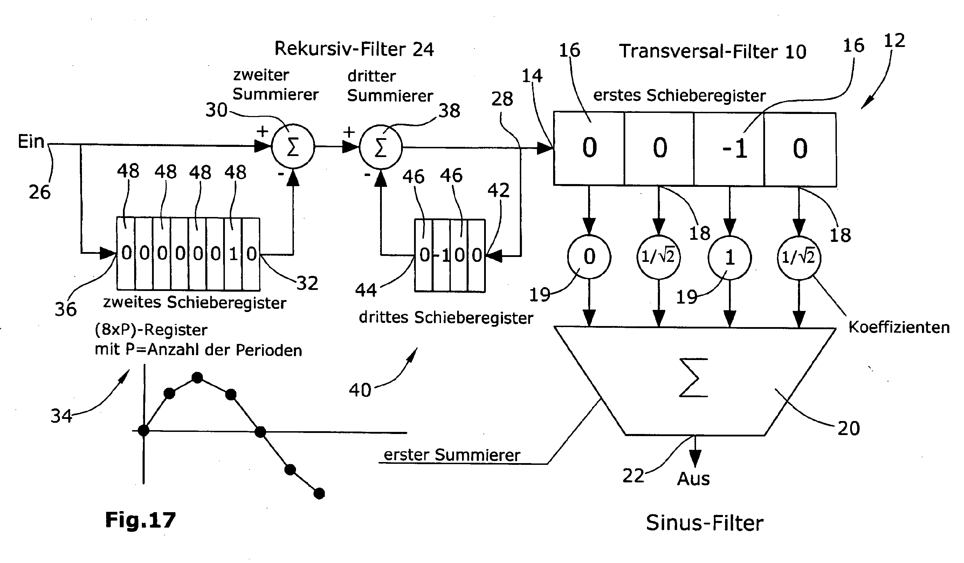

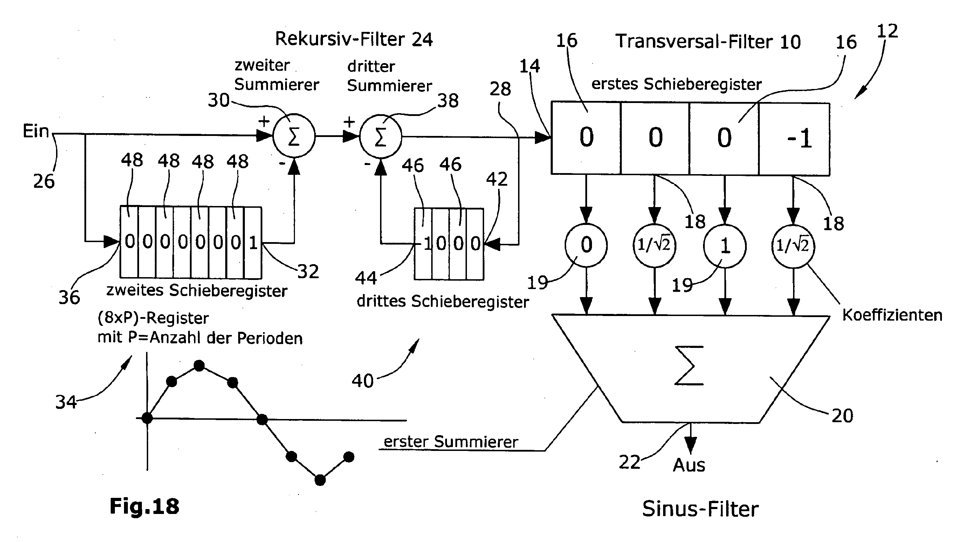

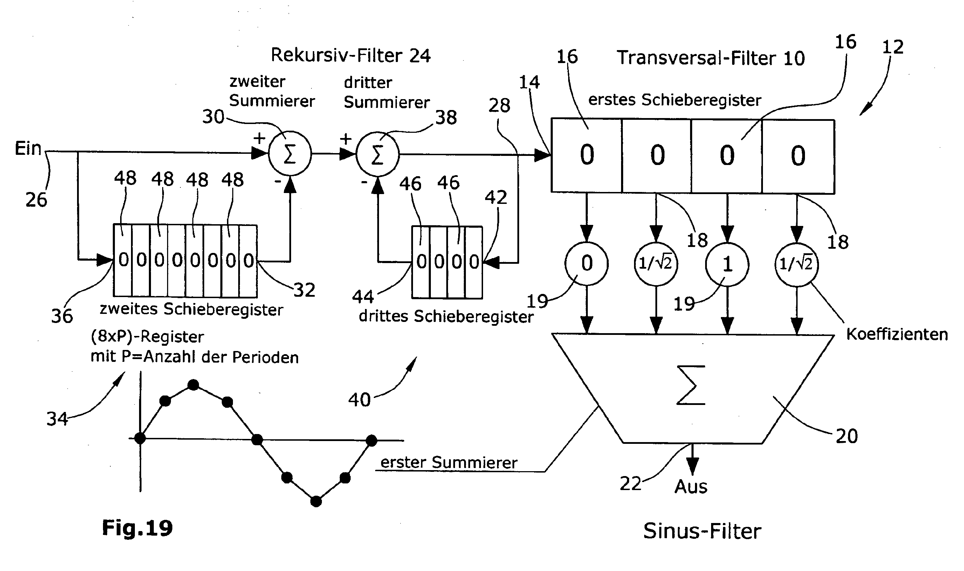

Anhand der Abbildungen 10 bis 19 wird deutlich, wie durch Anlegen eines Impulses (repräsentiert durch ein normiertes Signal mit dem Abtastwert "1" zum Zeitpunkt des Auftretens der Impulse und der Abtastwerte "0" zu den anderen Abtastzeitpunkten) am Eingang des Rekursiv-Filters, d.h. am Eingang des Optimal-Filters, an dessen Ausgang, d.h. am Ausgang des Transversal-Filters, eine gewünschte sinusförmige Impulsantwort entsteht. Hierbei wird davon ausgegangen, dass eine Sinushalbwelle (eine halbe Periode) durch vier Abtastwerte repräsentiert wird und ein sinusförmiges Burst-Signal mit einer Anzahl P von Perioden realisiert werden soll. Es sei an dieser Stelle angemerkt, dass die Konstruktion des Filters über die Impulsantwort lediglich eine von mehreren Entwurfsmethoden darstellt. Es existieren mehrere Realisierungen, die alle die gleiche Impulsantwort und damit identisches Verhalten aufweisen. Die inneren Filterzustände könnte man sich bei einem realen Signal auch bildlich vorstellen. Letzten Endes lässt sich aber jedes Signal aus einer Folge von sich überlagernden Impulsen unterschiedlicher Höhe zusammensetzen. Jeder Abtastwert ist im Prinzip ein solcher Impulse (eine Abtastung ist eine Multiplikation mit einem sogenannten Dirac-Kamm). Daher ist die Betrachtung einer einzelnen Impulsantwort ausreichend.

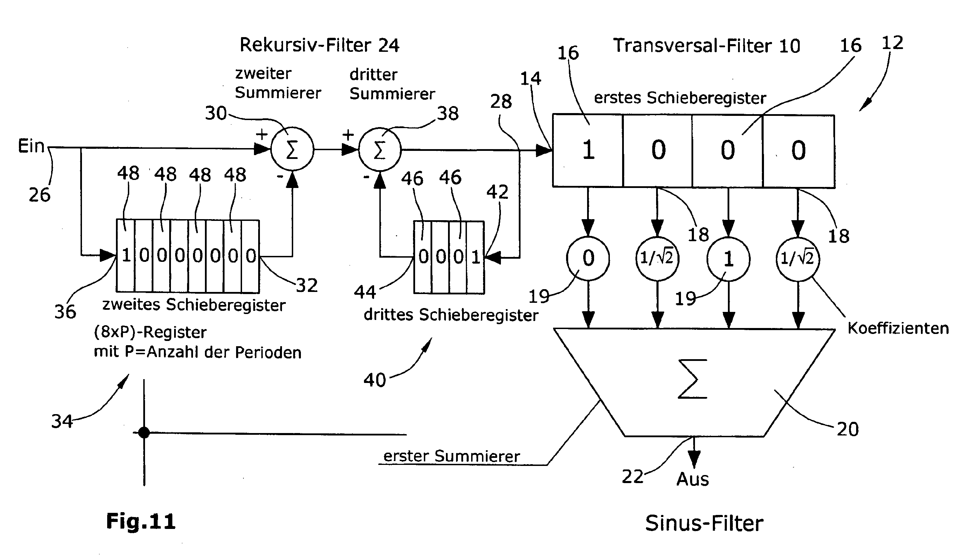

Abbildung 10 zeigt nochmals den Gesamtaufbau des digitalen Optimal-Filters mit Rekursiv-Filter und nachgeschaltetem Transversal-Filter. In Abbildung 11 ist nun die Situation angegeben, in der zum Zeitpunkt eines bestimmten (System-) Takts am Eingang In des digitalen Optimal-Filters der auf "1 0" normierte Impulswert angelegt ist. Dieser Wert befindet sich dann auch automatisch in der ersten (Register-)Zelle des zweiten Schieberegisters des Rekursiv-Filters. In der letzten Zelle des zweiten Schieberegisters ist eine "0" gespeichert, so dass das Ergebnis der Differenzbildung durch den zweiten Summierer "1" ist. Diese "1" liegt dann auch am Ausgang des Rekursiv-Filters an, da das dritte Schieberegister in seiner mit dem dritten Summierer verbundenen letzten Zelle eine "0" gespeichert hat. Die "1" wird auf das erste Schieberegister des Transversal-Filters gegeben und befindet sich dann in der ersten Zelle dieses ersten Schieberegisters, dessen Ausgang mit dem Koeffizienten 0 multipliziert wird. Die übrigen Zellen des ersten Schieberegisters sind mit "0" belegt. Im ersten Summierer wird also eine "0" erzeugt, so dass am Ausgang Out des digitalen Optimal-Filters also eine "0" anliegt, was auch in dem Diagramm gezeigt ist, in dem in den Abbildungen 11 bis 19 die schrittweise Entstehung des Verlaufs des sinusförmigen Signals wiedergegeben ist.

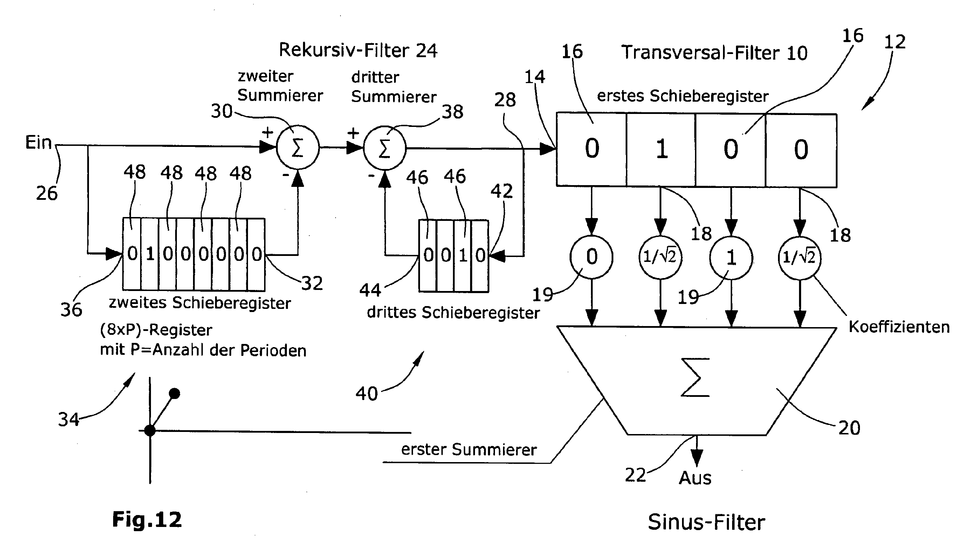

Mit der nächsten Taktung (siehe Abbildung 12) liegt am Eingang In des digitalen Optimal-Filters eine "0" an. Die beiden "1" in den ersten Zellen der zweiten und dritten Schieberegister werden durchgeschoben. Am Ausgang des Rekursiv-Filters entsteht eine "0" Damit wird die "1" im ersten Schieberegister des Transversal-Filters durch dieses hindurch in dessen zweite Zelle geschoben, deren Ausgang mit dem Koeffizient $1/\sqrt{2}$ multipliziert wird Am Ausgang Out liegt dann der Abtastwert nach einer 1/8 Periode an.

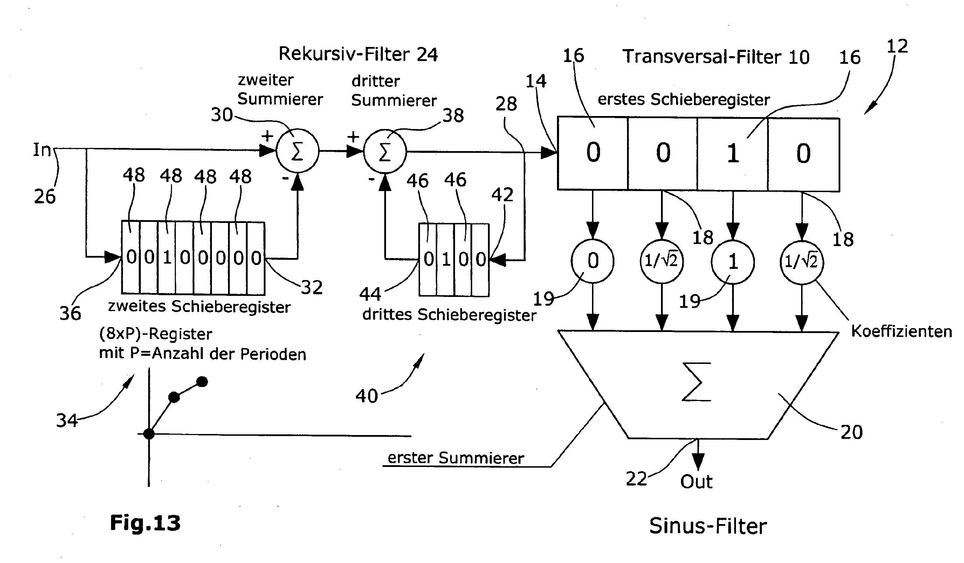

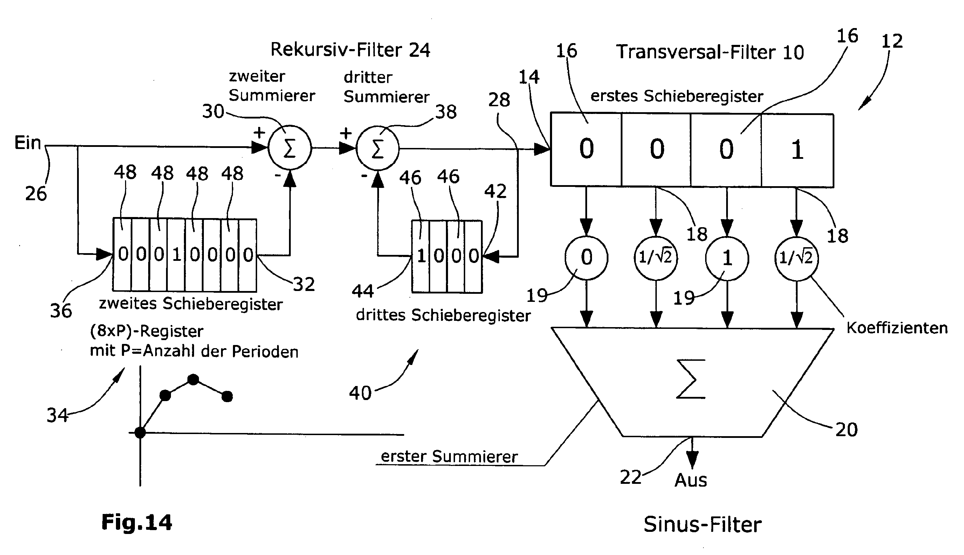

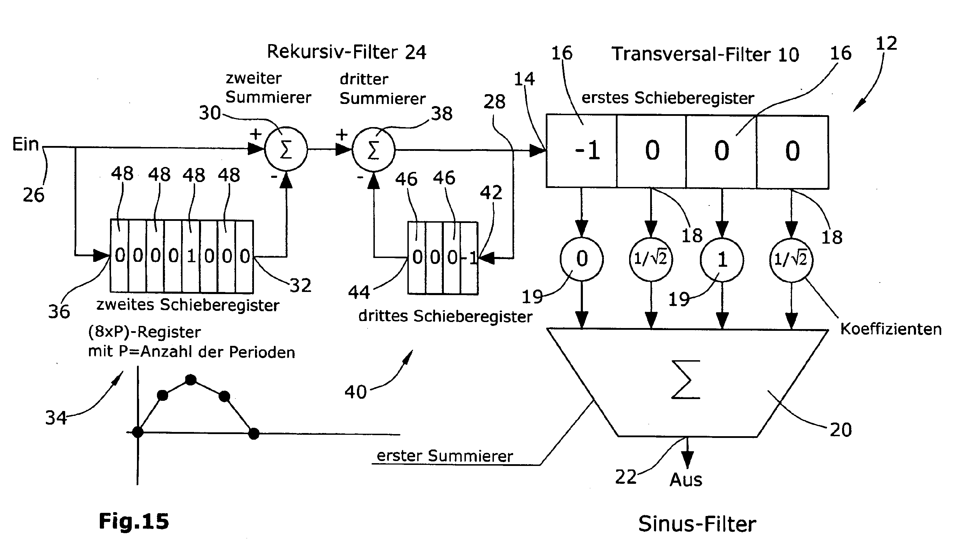

Dieses Verfahren wird weiter fortgesetzt, wie in den Abbildungen 13 bis 19 gezeigt, um die Impulsantwort am Ausgang des digitalen Optimal-Filters zu generieren Zu beachten ist noch, dass es ab der Situation gemäß Abbildung 15 zu einem "Vorzeichenwechsel" im dritten Schieberegister des Rekursiv-Filters kommt. Die Entstehung des Vorzeichenwechsels ergibt sich ausgehend von Abbildung 14, wenn weiterhin, wie bei einem impulsförmigen Eingangssignal üblich, am Eingang In des digitalen Optimal-Filters eine "0" anliegt; denn die mit dem dritten Summierer verbundene letzte Zelle des dritten Schieberegisters wird im dritten Summierer von der vom zweiten Summierer gelieferten "0" abgezogen und ergibt damit "-1".

Mit dem zuvor beschriebenen digitalen Optimal-Filter, dessen Verhalten anhand seiner Impulsantwort unter Bezugnahme auf die Abb. 10 bis 19 zuvor beschrieben worden ist, ist es also möglich, ein periodisches Wechselsignal mit einer vorgegebenen Periodenzahl, bei dem es sich im Ausführungsbeispiel um ein Burst-Signal handelt, aus einem verrauschten Ausgangssignal zu extrahieren.

## Patentansprüche

1. Digitales Optimal-Filter zum Herausfiltern eines periodischen Wechselsignals, insbesondere sinusförmigen Signals, mit einer vorgegebenen Periodenanzahl aus einem gegebenen Signal, mit

   - einem Transversal-Filter (10), das ein erstes Schieberegister (12) mit einem Eingang (14) und einer Anzahl von Zellen (16) aufweist, die gleich der Anzahl von Abtastwerten des erwarteten Verlaufs des herauszufilternden periodischen Wechselsignals über eine halbe Periode ist und die jeweils einen Ausgang (18) aufweisen, wobei den Ausgängen (18) Koeffizienten (19) zugeordnet sind, welche entsprechend den Abtastwerten bzw. gleich den Abtastwerten gewählt sind, und einem ersten Summierer (20) zum Summieren der mit den jeweils zugeordneten Koeffizienten gewichteten Ausgänge (18) der Zellen (16) des ersten Schieberegisters (12), wobei der Ausgang (22) des ersten Summierers (12) den Ausgang des Transversal-Filters (10) bildet, und
   - einem dem Transversal-Filter (10) vorgeschalteten Rekursiv-Filter (24), das einen Eingang (26) und einen mit dem Eingang (14) des Transversal-Filters (10) verbundenen Ausgang (28) aufweist,
   - wobei das Rekursiv-Filter (24)

       - einen mit seinem Eingang (26) verbundenen zweiten Summierer (30), der ferner mit dem Ausgang (32) eines zweiten Schieberegisters (34) verbunden ist, dessen Eingang (36) mit dem Eingang (26) des Rekursiv-Filters (24) verbunden ist,
- einen dritten Summierer (38), der mit dem Ausgang (28) des Rekursiv-Filters (24) verbunden ist, und
- ein drittes Schieberegister (40) aufweist, das einen mit dem Ausgang (28) des Rekursiv-Filters (24) verbundenen Eingang (42) und einen mit dem dritten Summierer (38) verbundenen Ausgang (44) aufweist,

- wobei die Anzahl der Zellen (46) des dritten Schieberegisters (40) zwischen dessen Ein- und Ausgang (42,44) gleich der Anzahl von Abtastwerten des Verlaufs des herauszuhlternden Signals über eine halbe Periode ist,
- wobei die Anzahl der Zellen (48) des zweiten Schieberegisters (34) zwischen dessen Ein- und Ausgang (36,32) gleich der Anzahl von Perioden des herauszufilternden Signals multipliziert mit der Anzahl von Abtastwerten des Verlaufs des herauszufilternden Signals über eine Periode ist,
- wobei der dritte Summierer (38) die Differenz aus dem von dem zweiten Summierer (30) gelieferten Ergebnis und dem Ausgang des dritten Schieberegisters (44) bildet und das Ergebnis dem Ausgang (28) des Rekursiv-Filters (24) zuführt,
- wobei dem Eingang (26) des Rekursiv-Filters (24) eine Serie von Abtastwerten des gegebenen Signals zuführbar ist und wobei die Gesamtanzahl dieser Abtastwerte gleich der Anzahl der Abtastwerte des erwarteten Verlaufs des herauszufilternden Signals pro Periode multipliziert mit der Anzahl von Perioden ist.

## Claims

1. A digital optimal filter for filtering out, from an original signal, a periodic alternating signal, particularly a sinusoidal signal, having a preset number of periods, said digital optimal filter comprising

- a transversal filter (10) comprising a first shift register (12) having an input (14) and a number of cells (16) which are equal to the number of sample values of the expected signal curve, over half a period, of the periodic alternating signal to be filtered out and which respectively have an output (18), said outputs (18) having assigned thereto coefficients (19) selected corresponding to the sample values and respectively selected to be identical to the sample values, and comprising a first summator (20) for summing the outputs (18) of the cells (16) of the first shift register (12) that have been weighted by the respectively assigned coefficients, the output (22) of the first summator (12) forming the output of the transversal filter (10), and
- a recursive filter (24) connected upstream of said transversal filter (10) and having an input (26) and an output (28), said output being connected to the input (14) of the transversal filter (10),
- said recursive filter (24) comprising

- a second summator (30) connected to the input (26) of the recursive filter and further connected to the output (32) of a second shift register (34), the input (36) of said second shift register being connected to the input (26) of the recursive filter (24),
- a third summator (38) connected to the output (28) of the recursive filter (24), and
- a third shift register (40) having an input (42) connected to the output (28) of the recursive filter (24) and having an output (44) connected to said third summator (38),

- the number of cells (46) of said third shift register (40) between the input and the output (42,44) thereof being equal to the number of sample values of the signal curve, over half a period, of the signal to be filtered out,
- the number of cells (48) of said second shift register (34) between the input and the output (36,32) thereof being equal to the number of periods of the signal to be filtered out, multiplied by the number of sample values of the signal curve, over one period, of the signal to be filtered out,
- said third summator (38) computing the difference between the outcome delivered by the second summator (30) and the output of the third shift register (44) and supplying said result to the output (28) of the recursive filter (24), and
- the input (26) of the recursive filter (24) being adapted to receive a series of sample values of the original signal, and the total number of said sample values being equal to the number of sample values of the signal curve, per period, of the signal to be filtered out, multiplied by the number of periods.

## Revendications

1. Filtre numérique optimal pour filtrer d'un signal donné un signal alternatif périodique, en particulier un signal sinusoïdal, comportant un nombre de périodes prédéterminées, comprenant :

- un filtre transversal (10) qui présente un premier registre à décalage (12) possédant une entrée (14) et un nombre de cellules (16) qui est égal au nombre des valeurs échantillonnées du profil attendu du signal alternatif périodique à filtrer sur une demi-période, cellules qui présentent chacune une sortie (18), des coefficients (19) qui sont choisis proportionnés aux valeurs échantillonnées ou égaux aux valeurs échantillonnées étant affectés aux sorties (18), et un premier totalisateur (20) destiné à totaliser les sorties (18) des cellules (16) du premier registre à décalage (12) pondérées avec les coefficients qui leur sont respectivement affectés, la sortie (22) du premier totalisateur (12) formant la sortie du filtre transversal (10), et
- un filtre récursif (24) connecté en amont du filtre transversal (10), qui présente une entrée (26) et une sortie (28) qui est reliée à l'entrée (14) du filtre transversal (10),
- le filtre récursif (24) présentant

- un deuxième totalisateur (30) relié à son entrée (26), qui est par ailleurs relié à la sortie (32) d'un deuxième registre à décalage (34) dont l'entrée (36) est reliée à l'entrée (26) du filtre récursif (24),
- un troisième totalisateur (38) qui est relié à la sortie du filtre récursif (24), et
- un troisième registre à décalage (40) qui présente une entrée (42) reliée à la sortie (28) du filtre récursif (24) et une sortie (44) reliée au troisième totalisateur (38),

- le nombre des cellules (46) du troisième registre à décalage (40) entre son entrée et sa sortie (42, 44) étant égal au nombre des valeurs échantillonnées du profil du signal à filtrer sur une demi-période,
- le nombre des cellules (48) du deuxième registre à décalage (34) entre son entrée et sa sortie (36, 32) étant égal au nombre des périodes du signal à filtrer multiplié par le nombre des valeurs échantillonnées du profil du signal à filtrer sur une période,
- le troisième totalisateur (38) formant la différence entre le résultat fourni par le deuxième totalisateur (30) et la sortie du troisième registre à décalage (44) et transmettant le résultat à la sortie (28) du filtre récursif (24),
- une série de valeurs d'échantillonnage du signal donné pouvant être envoyée à l'entrée (26) du filtre récursif (24) et le nombre total de ces valeurs échantillonnées étant égal au nombre des valeurs échantillonnées du profil attendu du signal à filtrer par période, multiplié par le nombre de périodes.

Ideales Burst-Signal

**Fig. 1**

Ungefiltertes Signal

**Fig.2**

Ausgangssignal nach Filter

Fig.3

Fig.4

9

$h(n)$

1

4    12    20    28

1 2 3   5 6 7 8 9 10 11   13 14 15 16 17 18 19   21 22 23 24 25 26 27   29 30 31 32   $n$

-1

**Fig.5**

38

Ein — + Σ ————————————————————— Aus

—

40

Schieberegister

**Fig.6**

30

Ein ————————————————— + Σ →Aus

34

—

Schieberegister (8xP Register)

P=Anzahl der Perioden

**Fig.7**

**Fig.8**

Rekursiv-Filter 24

Ein
26

48 48 48 48

30 38

44 46 46 42 28

Schieberegister ( 8xP Register)
p= Anzahl der Perioden

32

36

34

40

Schieberegister

Transversal-Filter 10

16 16 12

Schieberegister

14 18 18 18

18

0 $1/\sqrt2$ 1 $1/\sqrt2$

19 19

$\Sigma$

20

22 Aus

**Fig.9**

$H(z)$

$H_{sin\ cbp4}(z)$

$1-z^{-8P}$

$\dfrac{1}{1+z^{-4}}$

$z^{-8P}$

$z^{-4}$

$H_{fir2}(z)$

$c+z^{-1}+c*z^{-2}$

$x(n)$

$v(n)$

$y(n)$

c

$z^{-1}$

$z^{-1}$

c

Rekursiv-Filter 24

Transversal-Filter 10

zweiter Summierer

dritter Summierer

erstes Schieberegister

Ein

Koeffizienten

zweites Schieberegister

(8xP)-Register mit P=Anzahl der Perioden

drittes Schieberegister

Start/Stopp

Oszillator

erster Summierer

Aus

Sinus-Filter

**Fig.10**

EP 2 243 219 B1

Fig.11

Sinus-Filter

**Fig.12**

Transversal-Filter 10

erstes Schieberegister

12

16 16 16

0 0 1 0

14

18 18

($1/\sqrt{2}$) ($1/\sqrt{2}$) (1) (0)

19 19

20

$\sum$

22 → Out

Koeffizienten

Sinus-Filter

erster Summierer

Rekursiv-Filter 24

zweiter Summierer

dritter Summierer

38

28

42

46 46 46

0 1 0 0

44 drittes Schieberegister

40

30

32

48 48 48 48 48

0 0 1 0 0 0 0 0

36 zweites Schieberegister

(8xP)-Register
mit P=Anzahl der Perioden

In

26

34

**Fig.13**

15

Transversal-Filter 10

erstes Schieberegister

12
16
16

0 0 0 1

16
14

18 $1/\sqrt{2}$

18 $1/\sqrt{2}$   1

0

19

19

$\sum$

20

Koeffizienten

Aus

22

Sinus-Filter

28

42
0 0 0 0
46 46
46   1 0 0 0
44

drittes Schieberegister

Rekursiv-Filter 24

dritter Summierer

38

zweiter Summierer

30

$\sum$   -

$\sum$   -

32

40

erster Summierer

48 48 48
48 48 48
0 0 0 1 0 0 0 0

48

zweites Schieberegister
(8xP)-Register
mit P=Anzahl der Perioden

36

34

Ein

26

**Fig.14**

16

**Fig.15**

Rekursiv-Filter 24

Transversal-Filter 10

Sinus-Filter

Fig.16

Sinus-Filter

EP 2 243 219 B1

Fig.17

Sinus-Filter

Fig.18

Rekursiv-Filter 24

Transversal-Filter 10

Sinus-Filter

**Fig.19**

Sinus-Filter

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0285325 A